# EUROPÄISCHE PATENTANMELDUNG

(11) **EP 4 083 274 A2**
(43) Veröffentlichungstag der Anmeldung: **02.11.2022**
(21) Anmeldenummer: 22169524.0
(22) Anmeldetag: 22.04.2022
(51) Int. Cl.: C25D 17/00, C25D 17/12, C25B 11/043, C23C 14/00

(54) **ELEKTRODE UND VERFAHREN ZUM HERSTELLEN**

(30) Priorität: 26.04.2021 DE 102021110587
(71) Anmelder: CONDIAS GMBH, 25524 Itzehoe (DE)
(72) Erfinder: MATTHÉE, Thorsten, 25582 Hohenaspe (DE); MATHIAK, Dirk, 25581 Hennstedt (DE)
(74) Vertreter: Gramm, Lins & Partner Patent- und Rechtsanwälte PartGmbB

(57) **Zusammenfassung**

Die Erfindung betrifft eine Elektrode für ein elektrochemisches Reaktionsbad, wobei die Elektrode
a. einen Grundkörper,
b. eine Aktivseite, die eingerichtet ist, mit dem Reaktionsbad in Kontakt zu kommen und
c. eine Passivseite, die eingerichtet ist, mit wenigstens einem elektrischen Leiter in Kontakt zu kommen, aufweist
dadurch gekennzeichnet, dass die Passivseite eine dotierte Kohlenstoffbeschichtung aufweist.

## Beschreibung

Die Erfindung betrifft eine Elektrode für ein elektrochemisches Reaktionsbad, wobei die Elektrode einen Grundkörper, eine Aktivseite, die eingerichtet ist, mit dem Reaktionsbad in Kontakt zu kommen und eine Passivseite aufweist, die eingerichtet ist, mit wenigstens einem elektrischen Leiter in Kontakt zu kommen. Die Erfindung betrifft zudem ein Verfahren zum Herstellen einer solchen Elektrode.

Derartige Elektroden können eine Aktivseite mit einer dotierten Diamantbeschichtung aufweisen. Sie werden Diamantelektroden genannt und sind seit langer Zeit bekannt. Die vorliegende Erfindung ist jedoch nicht auf Diamantelektroden beschränkt, auch wenn sie für viele Anwendungen vorteilhaft sind. Elektroden und insbesondere Diamantelektroden sind typischerweise nur auf der Aktivseite, die mit dem Reaktionsbad in Kontakt kommt, beschichtet. Die vorzugsweise der Aktivseite gegenüberliegende Passivseite bleibt vorzugsweise unbeschichtet. Die Elektrode wird so in das Reaktionsbad eingesetzt, dass lediglich die beschichtete Aktivseite mit dem Reaktionsbad in Kontakt kommt. Auf der Passivseite wird die Elektrode mittels des wenigstens einen elektrischen Leiters elektrisch kontaktiert, also in Kontakt gebracht. Eine übliche Methode, das Reaktionsbad gegen die Atmosphäre abzudichten oder ein Austreten des Reaktionsbades zu verhindern, besteht darin, die entsprechende Dichtung an der Aktivseite der Elektrode anzuordnen. Dies hat unter anderem den Vorteil, dass die Passivseite vollflächig für die elektrische Kontaktierung verwendet werden kann. Es ist jedoch nicht notwendig, die Dichtung an der Aktivseite der Elektrode anzuordnen. Zusätzlich oder alternativ dazu ist es auch möglich, eine Dichtung an der Passivseite der Elektrode zu verwenden.

Auch für die elektrische Kontaktierung sind eine Reihe unterschiedlicher Ausgestaltungen bekannt. Sie weist in der Regel eine Vielzahl einzelner Kontaktstellen auf, durch die jeweils nur ein kleiner Anteil des elektrischen Stromes von einer Stromquelle auf die Elektrode übertragen wird. Die einzelnen Kontakte sind vorzugsweise als Stifte, besonders bevorzugt in Richtung auf die Elektrode federbelastet, ausgebildet, die vorteilhafterweise aus einem elektrisch gut leitenden Material, insbesondere einem Metall, beispielsweise Kupfer, hergestellt sind. Alternativ oder zusätzlich dazu kann die Kontaktierung auch als vollflächige oder teilflächige Kontaktplatte ausgebildet sein, wobei sich vorzugsweise zwischen der Kontaktplatte und dem Grundkörper der Elektrode eine Vlieslage befindet. Diese bildet eine Vielzahl von Einzelkontakten, die den elektrischen Strom transportieren.

Im Betrieb einer solchen Elektrode kann es aufgrund von Temperaturänderungen dazu kommen, dass sich die Dimensionen, also die Abmessungen der Elektrode in wenigstens einer Raumrichtung, allgemein jedoch in mehreren Raumrichtungen ändert. Daher ist es von Vorteil, wenn die einzelnen elektrischen Kontakte nicht fest und unlösbar mit der Elektrode verbunden sind. Dies gilt sowohl für als Einzelelemente, beispielsweise Stifte ausgebildete Kontakte als auch für Kontakte in Form eines Vlieses oder ohne Verwendung eines Vlieses. Dadurch wird eine Relativbewegung zwischen den Kontakten, also den elektrischen Leitern, und der Elektrode möglich.

Leckagen der Dichtung, die das Reaktionsbad gegen die Atmosphäre abdichtet, können zu aggressiven und korrosiven Gasphasen außerhalb des eigentlichen Reaktionsbades führen. Diese sind insbesondere im Bereich der Passivseite nachteilig, da eine Korrosion, Oxidierung oder sonstige Veränderung des Materials des Grundkörpers und/oder der elektrischen Leiter den elektrischen Kontakt bei zumindest einigen der Kontakte verschlechtern oder vollständig unterbrechen können. Ist das der Fall, muss der elektrische Strom, der durch die Kontakte auf die Elektrode übertragen wird, durch weniger Kontakte fließen. Die Stromdichte und damit auch die thermische Belastung der verbleibenden Kontakte steigt und führt zu weiteren Ausfällen. Dies gilt auch für Elektroden mit einem Grundkörper, der aus Silizium hergestellt wurde. Zudem kann es durch die lokale Temperaturerhöhung an den verbleibenden Kontakten auch zu einer lokalen Temperaturerhöhung am Grundkörper der Elektrode kommen, der dadurch auch beschädigt werden kann.

Silizium wird vorzugsweise mit einem spezifischen Widerstand von weniger als 20 mOhm*cm verwendet. Dazu muss es gegebenenfalls dotiert werden.

Aus dem Stand der Technik ist es bekannt, für die elektrische Kontaktierung Metallschichten mit hoher elektrischer Leitfähigkeit zu verwenden, beispielsweise aus Kupfer, Silber oder

Gold. Aus der EP 2 826 576 B1 ist beispielsweise ein Kontaktmaterial auf Silberbasis bekannt. Die EP 1 433 867 B1 beschreibt eine weitere Art von Kontaktwerkstoff auf Silber- oder Zinnbasis. Diese können mit entsprechenden Haftvermittlern und einer Oberflächenkonditionierung des Grundkörpers aus Silizium haftfest auf der Passivseite befestigt werden. Die Verwendung von Metallen ist jedoch in vielen Anwendungen der Elektroden, beispielsweise in der Halbleitertechnik, nicht möglich, um eine metallische Kontamination zu vermeiden. Zudem kommt es bei metallischen Beschichtungen oftmals zur Bildung einer Oxidationsschicht mit den damit verbundenen Nachteilen.

Der Erfindung liegt die Aufgabe zugrunde, die Nachteile aus dem Stand der Technik zu vermeiden oder zumindest zu vermindern.

Die Erfindung löst die gestellte Aufgabe durch eine Elektrode gemäß dem Oberbegriff des Anspruchs 1, die sich dadurch auszeichnet, dass die Passivseite eine dotierte Kohlenstoffverbindung aufweist. Obwohl der spezifische elektrische Widerstand einer Kohlenstoffschicht etwa drei Größenordnungen größer ist, als der eines der oben genannten Metalle, lässt sich durch die dotierte Kohlenstoffbeschichtung eine Schicht auf die Passivseite des Grundkörpers der Elektrode aufbringen, die einerseits eine ausreichend gute elektrische Kontaktierung und andererseits eine gute Schutzwirkung gegen aggressive und/oder korrosive Gasphasen bietet. Dies gilt auch im Falle von Flüssigkeits-Leckagen, die zur Folge haben, dass der Elektrolyt flüssig mit der Passivseite der Elektrode in Berührung kommt.

Der Erfindung liegt die Erkenntnis zugrunde, dass eine Kohlenstoffbeschichtung, insbesondere wenn sie als dotierte Diamantbeschichtung ausgeführt ist, den Verschleiß und die Korrosion auf der Passivseite der Elektrode stark vermindert und dennoch ausreichende Leitfähigkeit aufweist. Zudem kann eine raue Oberfläche der Kohlenstoffbeschichtung, insbesondere der Diamantbeschichtung auf die Einzelelemente oder Stifte, die zur Übertragung des elektrischen Stroms verwendet werden, aktivierend wirken, da eine an den Einzelelementen oder Stiften entstandene Oxidschicht durch die Relativbewegung zwischen Elektrode und Einzelelementen oder Stiften mechanisch abgetragen wird.

Vorzugsweise handelt es sich bei der dotierten Kohlenstoffbeschichtung um eine dotierte Diamantbeschichtung. Durch die Dotierung beispielsweise mit Bor wird die elektrische Leitfähigkeit der Diamantbeschichtung soweit erhöht, dass der zum Betrieb der Elektrode notwendige elektrische Strom übertragen werden kann.

Vorzugsweise ist der Grundkörper aus Silizium hergestellt. Alternativ oder zusätzlich dazu ist die dotierte Kohlenstoffbeschichtung mit Bor dotiert. Das Silizium ist vorzugsweise hochleitfähig eingestellt.

In einer bevorzugten Ausgestaltung weist die Elektrode an der Aktivseite eine dotierte Diamantbeschichtung auf, die vorzugsweise mit Bor dotiert ist.

Die Erfindung löst die gestellte Aufgabe zudem durch ein Verfahren zum Herstellen einer Elektrode der hier beschriebenen Art, wobei das Verfahren folgende Schritte aufweist:
a) Beschichten der Aktivseite des Grundkörpers mit einer dotierten Diamantbeschichtung,
b) Reinigen der Passivseite,
c) Beschichten der Passivseite mit der dotierten Kohlenstoffbeschichtung.

Im Verfahrensschritt a) wird zunächst die Aktivseite des Grundkörpers mit einer dotierten Diamantbeschichtung versehen. Dies geschieht vorzugsweise über eine Gasphasenabscheidung, die als CVD (chemical vapor deposition)-Verfahren aus dem Stand der Technik bekannt ist. Dabei ist es von Vorteil, wenn diese Beschichtung lediglich auf der Aktivseite des Grundkörpers stattfindet. Dies ist jedoch bei einer Gasphasenbeschichtung nur schwer umzusetzen, sodass auch die der Aktivseite gegenüberliegende Passivseite des Grundkörpers eine geringe Beschichtung aufweist, nachdem der Verfahrensschritt a) durchgeführt wurde. Durch geeignete Wahl von Abständen zwischen Grundkörpern, die in einem einzigen Verfahrensschritt gleichzeitig beschichtet werden, lässt sich die Beschichtung der jeweiligen Passivseite der Grundkörper reduzieren.

Daher wird im Verfahrensschritt b) die Passivseite des Grundkörpers gereinigt. Dabei werden Ablagerungen und Abscheidungen, die im Verfahrensschritt a) auf die Passivseite des Grundkörpers aufgebracht wurden, entfernt. Die so gereinigte Passivseite wird dann mit einer dotierten Kohlenstoffbeschichtung beschichtet. Auch dies geschieht vorzugsweise in einem CVD-Verfahren.

Die dotierte Kohlenstoffbeschichtung ist dabei nur in dem Bereich der Passivseite notwendig, der für die elektrische Kontaktierung verwendet wird. Bei einer vollflächigen Kontaktierung wird ein flächiges Kontaktelement, beispielsweise eine Platte, an der Passivseite angeordnet, vorzugsweise gegen diese gedrückt. In diesem Fall ist die ganze Passivseite mit der dotierten Kohlenstoffbeschichtung zu versehen. Wird nur eine teilflächige Kontaktierung verwendet, bei der ebenfalls wenigstens ein flächiges Kontaktelement verwendet wird, dessen Oberfläche jedoch kleiner als die Passivseite der Elektrode ist, ist nur der Bereich der Passivseite mit der dotierten Kohlenstoffbeschichtung zu versehen, der mit dem wenigstens einen Kontaktelement in Kontakt kommt. Es kann von Vorteil sein, mehrere flächige Kontaktelemente, beispielsweise zwei, drei oder vier, zu verwenden. Es kann von Vorteil sein, auch bei einer teilflächigen Kontaktierung die gesamte Passivseite der Elektrode mit der dotierten Kohlenstoffbeschichtung zu versehen.

Bei einer Kontaktierung durch Stifte oder ähnliche Elemente muss ebenfalls nur der Bereich der Passivseite mit der dotierten Kohlenstoffbeschichtung versehen werden, der mit den Kontaktelementen in Berührung kommt. Eine Beschichtung einer größeren Fläche, vorzugsweise der gesamten Passivseite, ist von Vorteil.

Wird wenigstens ein flächiges Kontaktelement verwendet, ist es von Vorteil, die Passivseite vor dem Beschichten mit der dotierten Kohlenstoffbeschichtung zu schleifen und gegebenenfalls zu ätzen. Auch ohne flächiges Kontaktelement kann die Passivseite so behandelt werden.

Vorzugsweise wird vor dem Beschichten der Passivseite die Passivseite geschliffen, wobei besonders bevorzugt Material des Grundkörpers abgetragen wird. Das Beschichten der Aktivseite des Grundkörpers führt zu einer leichten Verbiegung und Deformation des Grundkörpers, wodurch sich auch die Passivseite des Grundkörpers verformt. Insbesondere hat dies Auswirkungen auf die Planizität der Passivseite des Grundkörpers. Daher wird im Verfahrensschritt b) die Passivseite nicht nur gereinigt, sondern auch plan geschliffen. Eine Verbiegung der Passivseite erschwert eine gleichmäßige elektrische Kontaktierung der Passivseite, insbesondere bei vollflächiger oder teilflächiger Kontaktierung, bei denen eine möglichst homogene Stromverteilung über die verschiedenen Einzelkontakte erzielt werden soll. Außerdem werden beim Schleifen der Passivseite Rückstände entfernt, die sich bei der CVD-Beschichtung auf der Passivseite gebildet haben könnten. Besonders vorzugsweise steht nach dem Reinigen der Passivseite eine native Siliziumoberfläche zur Verfügung. Das Schleifen der Passivseite ist besonders von Vorteil, wenn eine großflächige, vorzugsweise vollflächige Kontaktierung der Passivseite erfolgen soll. Werden nur Einzelelemente oder Stifte verwendet, ist der Effekt des Schleifens kleiner, allerdings auch von Vorteil.

In einer bevorzugten Ausgestaltung wird der zu schleifende Grundkörper, auf dessen Aktivseite sich bereits eine dotierte Diamantbeschichtung befindet, zum Schleifen auf eine Auflage gelegt, die die beschichtete Aktivseite besonders schützt. Hierzu wird beispielsweise eine Folienanordnung verwendet, die geringe Unebenheiten der beschichteten Aktivseite ausgleicht und gleichzeitig mechanische Stöße und Beschädigungen verhindert. Vorzugsweise wird ein zweiteiliger Schleifprozess verwendet. In einem ersten Schleifschritt werden die mit dem Diamant beschichteten Bereiche der Passivseite entfernt. Auch andere parasitär abgeschiedene Kohlenstoffschichten, beispielsweise Graphit oder amorpher Kohlenstoff, werden in diesem Verfahrensschritt entfernt. Dabei erfolgt möglichst keine Zustellung in die Siliziumoberfläche. Wenn die Kohlenstoffschichten von der Passivseite entfernt wurden, wird in einem zweiten Schleifschritt das Material des Grundkörpers, vorzugsweise Silizium, abgetragen. Mit jedem Schleifschritt werden beispielsweise 10 µm Zustellungen geschliffen. Mehrere derartige Schleifschritte können nacheinander durchgeführt werden, wobei es sich als vorteilhaft herausgestellt hat, wenn max. fünf derartige Zustellungen verwendet werden, sodass max. 50 µm Material des Grundkörpers abgetragen werden.

Vorzugsweise wird die Passivseite nach dem Schleifen einer Ätzbehandlung, insbesondere mit Kaliumhydroxid (KOH_{aq}) oder Flusssäure (HF_{aq}) unterzogen. Die Passivseite kann mit Wasserstoff oder Schwefelsäure (H₂SO₄) geätzt werden, um Kohlenstoffanteile, insbesondere graphitische Anteile, zu entfernen. Die Behandlung mit Schwefelsäure ist dabei deutlich gröber. Wenn die Passivseite geschliffen wurde, sind in der Regel keine Kohlenstoffanteile oder graphitischen Anteile mehr an der Passivseite vorhanden. In diesem Fall kann die Passivseite mit Kaliumhydroxid geätzt werden, um beispielsweise Schleifschäden aus der Oberfläche zu entfernen.

In einer bevorzugten Ausgestaltung wird beim Reinigen der Passivseite die Passivseite in wenigstens einem Gasphasen-Ätz-Schritt, vorzugsweise mittels eines Wasserstoff (H₂)-Gases gereinigt. Durch ein Gasphasen-Ätzen wird die Oberfläche der Passivseite des Grundkörpers weiter gereinigt. Durch eine angepasste Diamantbekeimung kann erreicht werden, dass bei der anschließenden Beschichtung der Passivseite mit der dotierten Kohlenstoffbeschichtung möglichst wenig Schichtdefekte entstehen.

Vorzugsweise ist die dotierte Kohlenstoffbeschichtung weniger als 5 µm, bevorzugt weniger als 2 µm dick. Sie weist bevorzugt eine Dicke von wenigstens 1 µm auf. Es wird eine möglichst dünne Schichtdicke bei geschlossener, jedoch nicht notwendigerweise defektfreier Beschichtung angestrebt. Je geringer die Dicke der Kohlenstoffbeschichtung ist, desto geringer ist der Einfluss der Beschichtung auf den Grundkörper. Durch eine möglichst geringe Dicke der Beschichtung werden eine erneute Verbiegung des Grundkörpers sowie mechanische Spannungen verringert. Zudem werden die Kosten reduziert. Die Kohlenstoffbeschichtung ist vorzugsweise eine Diamantbeschichtung. Die kann jedoch auch als Graphitschicht oder eine Kombination aus Graphit- und Diamantschichten ausgebildet werden. Eine vollständige Defektfreiheit der Kohlenstoffschicht ist zwar von Vorteil, jedoch nicht notwendig. Die aufgebrachte Kohlenstoffbeschichtung wird nur punktuell an den einzelnen elektrischen Kontakten belastet.

Vorzugsweise weist die Passivseite vor dem Beschichten mit der dotierten Kohlenstoffbeschichtung eine Oberflächenrauhheit 0,2 µm < Rₐ < 0,6 µm und/oder nach dem Beschichten von R_{z} < 10 µm und/oder Rₐ < 1 µm auf.

In einer bevorzugten Ausgestaltung handelt es sich bei der dotierten Kohlenstoffbeschichtung um eine dotierte polykristalline Diamantbeschichtung in sp³-Konfiguration. Eine ebenfalls mögliche dotierte Kohlenstoffbeschichtung in sp²-Konfiguration weist eine geringere chemische Korrosionsbeständigkeit sowie schlechtere mechanische Eigenschaften auf. Kohlenstoffatome weisen im neutralen Grundzustand vier Elektronen in der äußersten Schale auf, von denen sich zwei im sogenannten "s"-Orbital und zwei im sogenannten "p"-Orbital befinden. Diese vier Orbitale hybridisieren in der Diamantstruktur zu den sogenannten "sp³"-Orbitalen.

## Patentansprüche

1. Elektrode für ein elektrochemisches Reaktionsbad, wobei die Elektrode
a. einen Grundkörper,
b. eine Aktivseite, die eingerichtet ist, mit dem Reaktionsbad in Kontakt zu kommen und
c. eine Passivseite, die eingerichtet ist, mit wenigstens einem elektrischen Leiter in Kontakt zu kommen, aufweist
**dadurch gekennzeichnet, dass**
die Passivseite eine dotierte Kohlenstoffbeschichtung aufweist.

2. Elektrode nach Anspruch 1, **dadurch gekennzeichnet, dass** die dotierte Kohlenstoffbeschichtung eine dotierte Diamantbeschichtung ist.

3. Elektrode nach Anspruch 1 oder 2, **dadurch gekennzeichnet, dass** der Grundkörper aus Silizium hergestellt ist und/oder die dotierte Kohlenstoffbeschichtung mit Bor dotiert ist.

4. Elektrode nach einem der vorstehenden Ansprüche, **dadurch gekennzeichnet, dass** die Aktivseite eine dotierte Diamantbeschichtung aufweist, wobei die Diamantbeschichtung vorzugsweise mit Bor dotiert ist.

5. Verfahren zum Herstellen einer Elektrode gemäß einem der vorstehenden Ansprüche, wobei das Verfahren folgende Schritte aufweist:
a. Beschichten der Aktivseite des Grundkörpers mit einer dotierten Diamantbeschichtung,
b. Reinigen der Passivseite
c. Beschichten der Passivseite mit der dotierten Kohlenstoffbeschichtung.

6. Verfahren nach Anspruch 5, **dadurch gekennzeichnet, dass** vor dem Beschichten der Passivseite die Passivseite geschliffen wird, wobei vorzugsweise Material des Grundkörpers abgetragen wird.

7. Verfahren nach Anspruch 6, **dadurch gekennzeichnet, dass** die Passivseite nach dem Schleifen einer Ätzbehandlung, insbesondere mit Kaliumhydroxid (KOH) oder Flusssäure (HF), unterzogen wird.

8. Verfahren nach Anspruch 5, 6 oder 7, **dadurch gekennzeichnet, dass** zum Reinigen der Passivseite die Passivseite in wenigstens einem Gasphasen-Ätz-Schritt vorzugsweise in einem Wasserstoff (H₂) - Gas gereinigt wird.

9. Verfahren nach einem der Ansprüche 5 bis 8, **dadurch gekennzeichnet, dass** die dotierte Kohlenstoffbeschichtung weniger als 5 µm, bevorzugt weniger als 2 µm dick, und vorzugsweise wenigstens 1 µm dick ist.

10. Verfahren nach einem der Ansprüche 5 bis 9, **dadurch gekennzeichnet, dass** die Passivseite vor dem Beschichten mit der dotierten Kohlenstoffbeschichtung eine Oberflächenrauhheit 0,2 µm < Rₐ < 0,6 µm und/oder nach dem Beschichten von R_{z} < 10 µm und/oder Rₐ < 1,0 µm aufweist.

11. Verfahren nach einem der Ansprüche 5 bis 10, **dadurch gekennzeichnet, dass** die dotierte Kohlenstoffbeschichtung eine dotierte polykristalline Diamantbeschichtung in sp³-Konfiguration ist.
